# EUROPEAN PATENT APPLICATION

(11) **EP 2 563 106 A2**
(43) Date of publication of application: **27.02.2013**
(21) Application number: 12169496.2
(22) Date of filing: 25.05.2012
(51) Int. Cl.: H05K 3/30, H05K 3/34

(54) **Lead component holder and electronic device**

(30) Priority: 26.07.2011 JP 2011163329
(71) Applicant: Kabushiki Kaisha Yaskawa Denki, Kitakyushu-Shi Fukuoka 806 (JP)
(72) Inventor: Sasahara, Kenta, Kitakyushu-shi, Fukuoka 806-0004 (JP); Mizumoto, Junya, Kitakyushu-shi, Fukuoka 806-0004 (JP); Sakai, Masafumi, Kitakyushu-shi, Fukuoka 806-0004 (JP)
(74) Representative: Viering, Jentschura & Partner

(57) **Abstract**

Provided is a lead component holder and an electronic device capable of improving vibration resistance performance. A lead component holder (10) includes a plurality of supporting portions (30a, 30b, 30c) each supporting one of lead components (C) at a position distant from a component mounting surface of a substrate (22), and at least one of coupling members (32a, 32b) respectively coupling the adjacent supporting portions (30a, 30b) and (30b, 30c) at a position distant from the component mounting surface. An electronic device (12) includes the substrate (22), the lead component holder (10), and an electronic component mounted to the substrate (22) located below the coupling members (32a, 32b).

## Description

### BACKGROUND OF THE INVENTION

### Field of the Invention

The present invention relates to a lead component holder and an electronic device.

### Description of the Related Art

Japanese Unexamined Patent Application Publication No. 2000-243656 describes an electronic component. The electronic component includes a cylindrical case with a bottom storing an element, a sealing member sealing an opening of the case, and a terminal with an attachment portion. The terminal is connected to an electrode extracting member of the element inside the case coupled to the sealing member. And, the attachment portion is formed at a tip end of the terminal projecting from an outer surface of the sealing member, and the attachment portion is attached to a printed wiring board. Further, the electronic component includes a gap-forming portion of a predetermined length. The gap-forming portion is formed between a joint surface of the terminal with the sealing member and the attachment portion in the tip end.
An object of the disclosure is to provide a lead component holder and an electronic device capable of improving vibration resistance performance.

### SUMMARY OF THE INVENTION

To achieve the above object, a lead component holder according to a first aspect of the disclosure includes a plurality of supporting portions each supporting a lead component at a position distant from a component mounting surface of a substrate, and at least one coupling member coupling the adjacent supporting portions at a position distant from the component mounting surface. Each supporting portion includes a base member attached to the component mounting surface and having a hole into which a lead of the lead component is inserted, and a supporting frame provided on the base member and into which the lead component is inserted.

To achieve the above object, an electronic device according to a second aspect of the disclosure includes a substrate, a lead component holder having a plurality of supporting portions each supporting a lead component at a position distant from a component mounting surface of the substrate, and at least one coupling member coupling the adjacent supporting portions at a position distant from the component mounting surface, and an electronic component mounted to the substrate located below the coupling member. Each supporting portion includes a base member attached to the component mounting surface and having a hole into which a lead of the lead component is inserted, and a supporting frame provided on the base member and into which the lead component is inserted.

### EFFECT OF THE INVENTION

According to the disclosure, it is possible to improve the vibration resistance performance as compared to a case not employing the configuration of the disclosure.

### BRIEF DESCRIPTION OF THE DRAWINGS

Fig. 1 is an internal structural diagram of an inverter containing a printed circuit board with a lead component holder according to one embodiment mounted;
Fig. 2 is an enlarged view of the lead component holder fixed to the printed circuit board;
Fig. 3A is a perspective view of the lead component holder;
Fig. 3B is a perspective view of the lead component holder viewed from an angle different from Fig. 3A;
Fig. 3C is a perspective view of the lead component holder viewed from an angle different from Fig. 3A and Fig. 3B;
Fig. 4A is a plan view of the lead component holder;
Fig. 4B is a front elevational view of the lead component holder;
Fig. 5 is a perspective view illustrating the lead component holder in use;
Fig. 6 is a plan view illustrating a modified example of the lead component holder;
Fig. 7A is an illustrative view showing an insulation distance when the lead component holder is not used;
Fig. 7B is an illustrative view showing an insulation distance when the lead component holder is used; and
Fig. 8 is an exploded view of an electrolytic capacitor, the lead component holder, and the printed circuit board.

### DESCRIPTION OF THE EMBODIMENTS

With reference to the appended drawings, embodiments are described for better understanding of the disclosure. In each of the drawings, some of components that do not related to the description may not be illustrated.

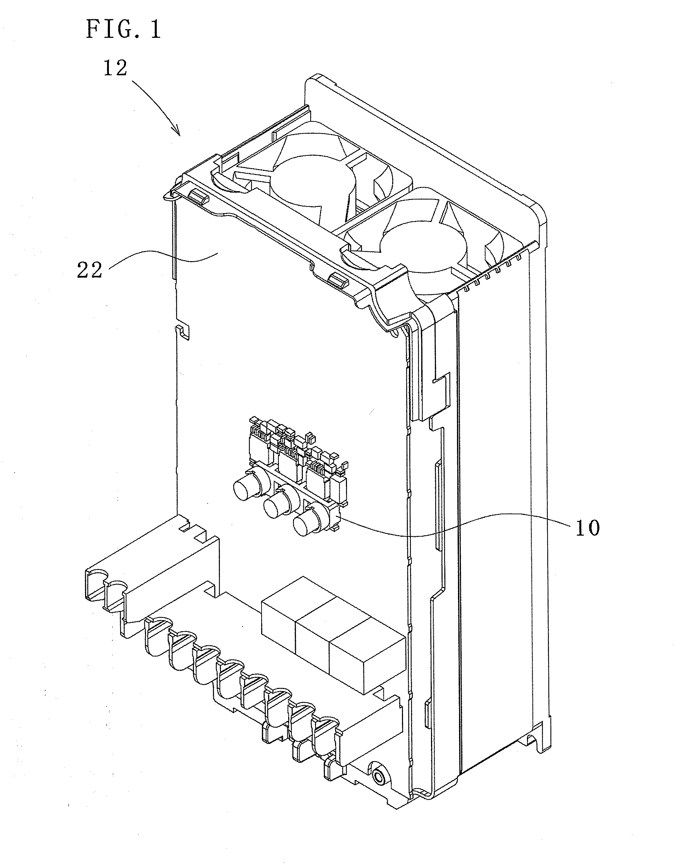

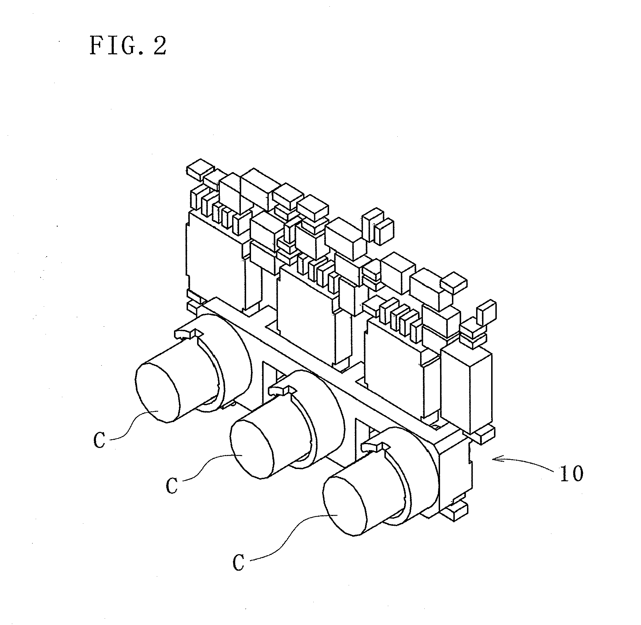

A lead component holder 10 according to one embodiment is mounted on a printed circuit board (one example of a substrate) 22 provided in an inverter (one example of an electronic device) 12 illustrated in Fig. 1, for example.
As illustrated in Fig. 2, the lead component holder 10 can support a cylindrical polarized capacitor (one example of a lead component, hereinafter simply referred to as the "capacitor") C at a position distant from a component mounting surface of the printed circuit board 22. The capacitor C supported by the lead component holder 10 is electrically connected to the printed circuit board 22.

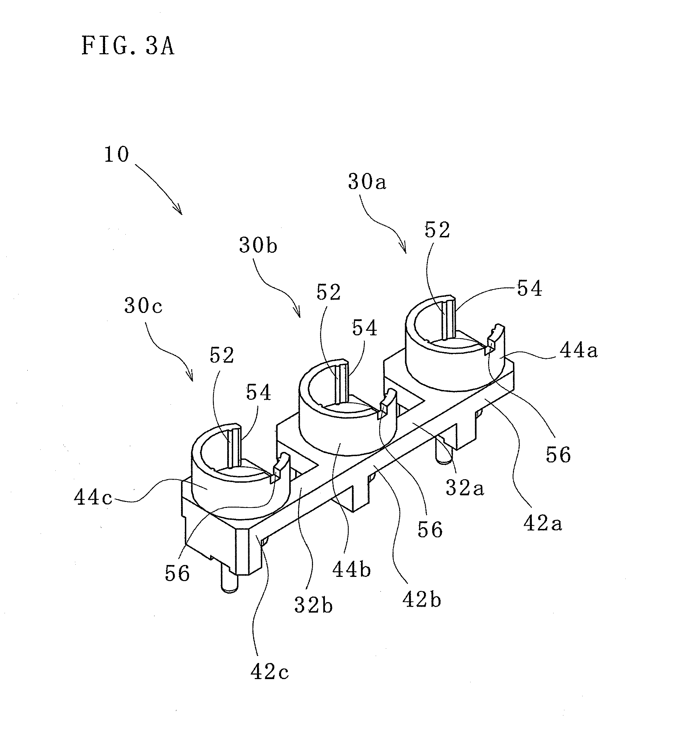

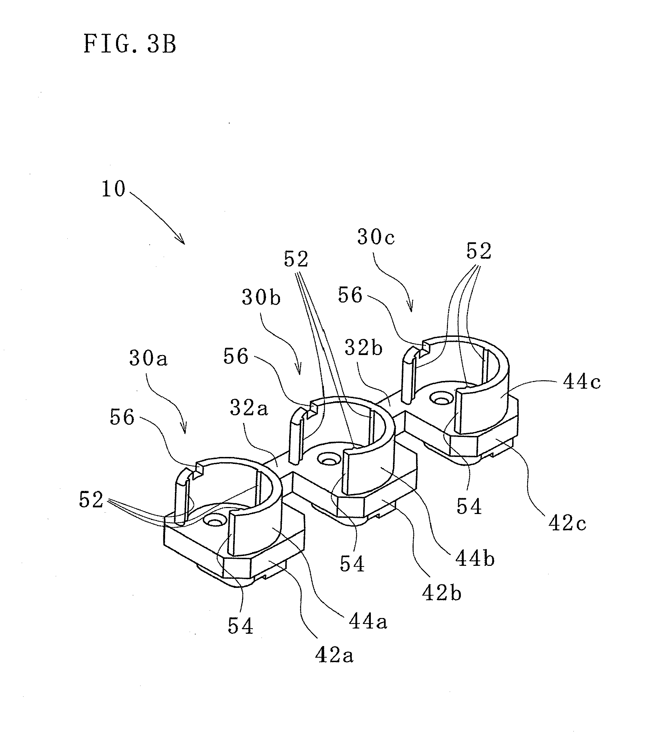

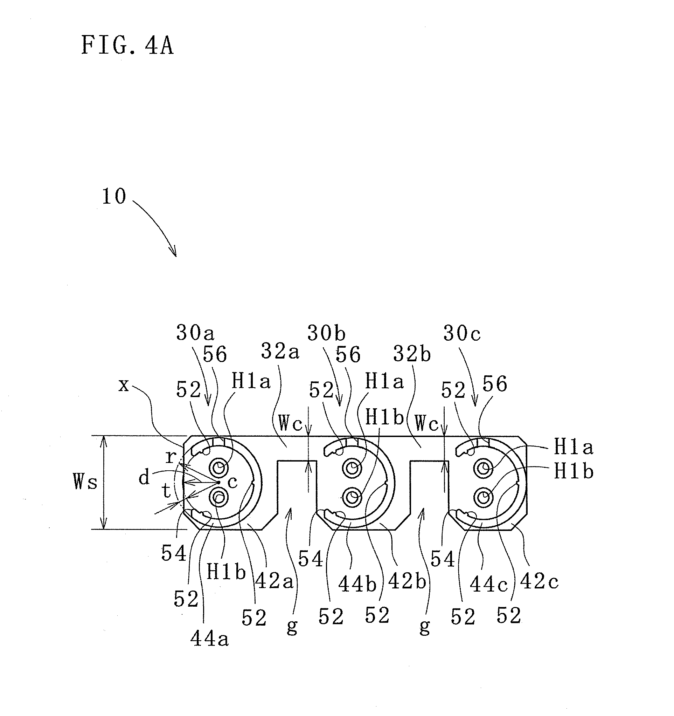

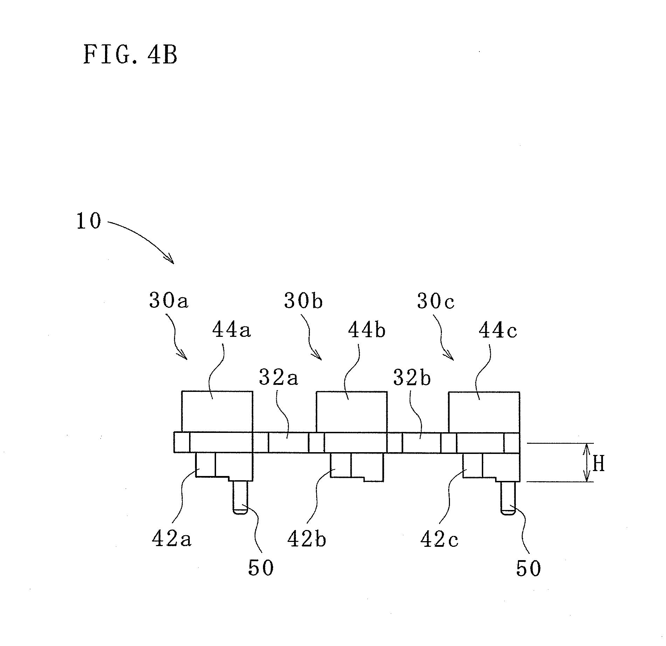

The lead component holder 10 includes a plurality of supporting portions and at least one coupling member coupling the adjacent supporting portions.
Specifically, as illustrated in Fig. 3A to Fig. 3C, Fig. 4A, and Fig. 4B, the lead component holder 10 includes first to third supporting portions 30a, 30b, and 30c and first and second coupling members 32a and 32b that are aligned in one direction.

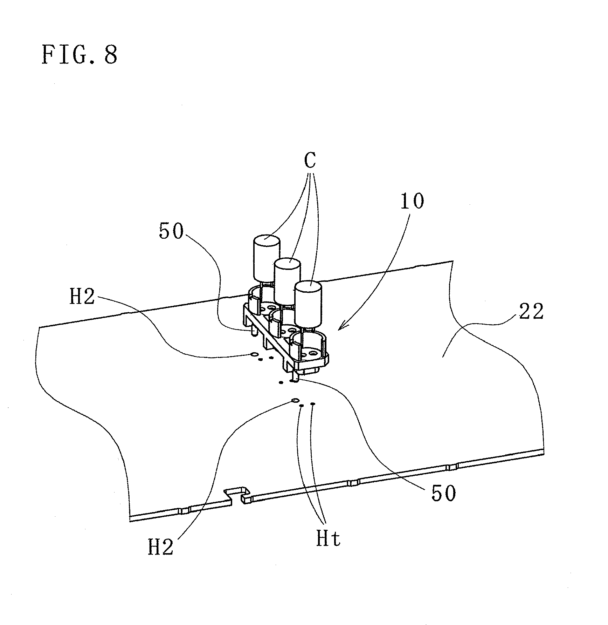

The first to third supporting portions 30a, 30b, and 30c respectively include base members 42a, 42b, and 42c and supporting frames (one examples of the supporting members) 44a, 44b, and 44c respectively provided on the base members 42a, 42b, and 42c.
The base members 42a, 42b, and 42c are attached to the component mounting surface of the printed circuit board 22. Each of the base members 42a, 42b, and 42c includes a pair of holes H1a and H1b such that an axial center of the holes intersects with the component mounting surface. Through the pair of holes H1a and H1b, a pair of lead wires extending from a bottom surface of the capacitor C are respectively inserted. The pair of holes H1a and H1b are provided in a direction intersecting with a coupling direction of the coupling members 32a and 32b. The lead wires of the capacitor C respectively pass through the holes H1a and H1b, and are soldered to through holes Ht provided on the printed circuit board 22 at corresponding positions (see Fig. 8).

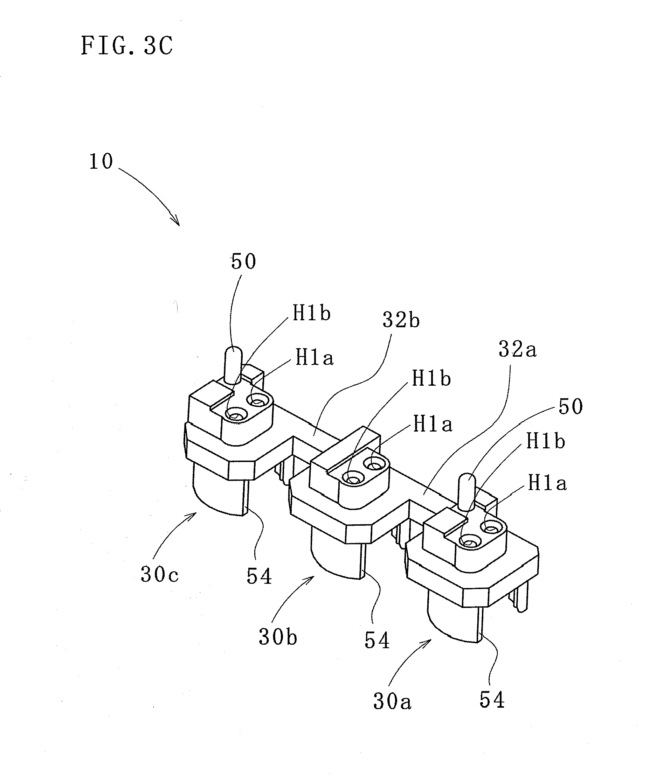

Each of the base members 42a and 42c includes a positioning pin 50 on a side opposite to a side supporting the capacitor C, i.e., on a side of the printed circuit board 22 (see Fig. 3C and Fig. 4B). The positioning pins 50 are respectively inserted into holes H2 (see Fig. 8) provided in the printed circuit board 22, and adhered to the printed circuit board 22 by an adhesive agent, for example.
The positioning pins 50 are provided only in the base members 42a and 42c that are positioned on both ends of the lead component holder 10. The positioning pins 50 are only provided only in the first and third supporting portions 30a and 30c, which are positioned on the both ends, out of the plurality of supporting portions 30a, 30b, and 30c. Thus, it is possible to reduce the number of the holes for fixing the lead component holder 10, and to improve packaging density of the printed circuit board 22.

Each of the supporting frames 44a, 44b, and 44c can support a side surface of the capacitor C. Each of the supporting frames 44a, 44b, and 44c is a circular cylindrical shape having an outer circumference cut out. An inner wall of each of the supporting frames 44a, 44b, and 44c includes three contact members 52 projecting from the inner wall and extending in a direction of an axis of the capacitor C. An amount (i.e., a length) of each of the three contact members 52 projecting from the inner wall increases toward a direction of insertion of the capacitor C, i.e., toward the printed circuit board 22. Therefore, the contact members 52 are brought into contact with at least a lower side surface of the capacitor C and support the capacitor C.

Each of the supporting frames 44a, 44b, and 44c includes a first cut-out 54. Specifically, a portion of each of the supporting frames 44a, 44b, and 44c is cut out in a circumferential direction to form the first cut-out 54. The first cut-outs 54, not facing toward each other, are provided in a coupling direction that the coupling members 32a and 32b are coupled to each other.
The first cut-outs 54 are provided respectively for the supporting frames 44a, 44b, and 44c. When the capacitors C are inserted into the corresponding frames, the supporting frames 44a, 44b, and 44c are flexed and internal diameters of the supporting frames 44a, 44b, and 44c expand. In addition, as described above, the amount of the three contact members 52 projecting from the inner wall increases toward the direction of insertion of the capacitor C, i.e., toward the printed circuit board 22. Thus, the capacitors C inserted into the supporting frames 44a, 44b, and 44c are supported in a stable manner, which further improves vibration resistance performance.
Moreover, as illustrated in Fig. 4A showing the lead component holder 10 in planar view, provided that (1) a center point of the cylindrical supporting frame 44a is a point C, (2) an external side of the base member 42a forming an outline of the lead component holder 10 and in contact with an inner circumferential circle of the cylindrical supporting frame 44a is a side x, (3) a distance from the side x to the center point C is a distance d, and (4) a radius of an outer circumferential circle of the cylindrical supporting frame 44a is a radius r, then the first cut-out 54 is placed next to the side x of the supporting frame 44a disposed at an end of the lead component holder 10, and the distance d is smaller than the radius r. Accordingly, as compared to a case without the first cut-out 54 (see a two-dot chain line in Fig. 4A), the outline of the lead component holder 10 becomes smaller by an amount of a thickness t of the supporting frame 44a (a difference between the radius r and the distance d), and an area for mounting the lead component holder 10 is reduced.

Each of the supporting frames 44a, 44b, and 44c includes a second cut-out (one example of a marking point) 56 indicating a polarity position of the capacitor C.
The second cut-out 56 is provided, for example, at an upper end portion of each of the supporting frames 44a, 44b, and 44c. Further, the second cut-out 56 is provided in a direction different from the coupling direction that the first to third supporting portions 30a, 30b, and 30c are coupled.
Therefore, even when the capacitor C is supported by the lead component holder 10, the second cut-out 56 can be visually confirmed from outside without being blocked by the capacitor C.
Here, each of the base members 42a, 42b, and 42c includes the pair of holes H1a and H1b into which the lead wires are inserted. By changing an orientation (a direction of arrangement) of the pair of holes H1a and H1b, the first cut-out 54 can be formed as a marking point, without providing the second cut-out 56.

The first coupling member 32a couples the first supporting portion 30a and the second supporting portion 30b at a position distant from the component mounting surface (at a height H shown in Fig. 4B). The second coupling member 32b couples the second supporting portion 30b and the third supporting portion 30c at a position distant from the component mounting surface (at the height H).
As illustrated in Fig. 4A, in planar view (when viewed from a side on which the capacitor C is supported), each of the first and second coupling members 32a and 32b is configured such that a width Wc of the coupling members 32a and 32b in the direction intersecting with the coupling direction becomes smaller than a width Ws of the first to third supporting portions 30a, 30b, and 30c in the direction intersecting with the coupling direction.

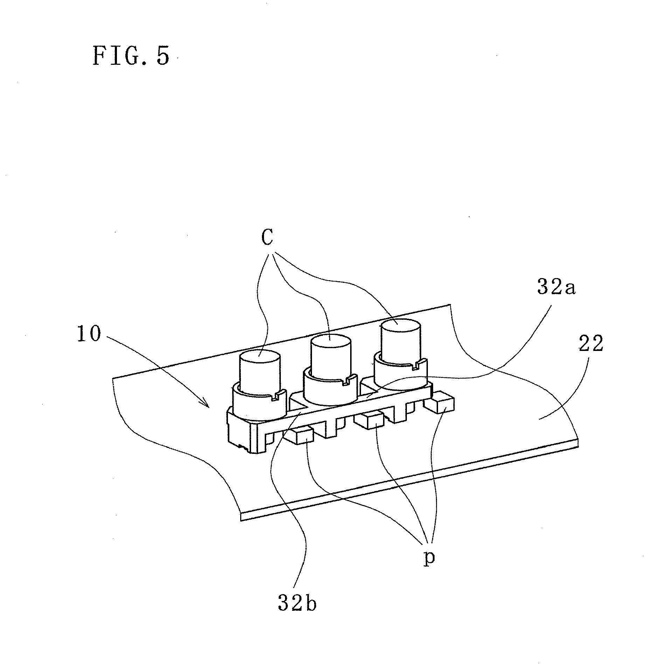

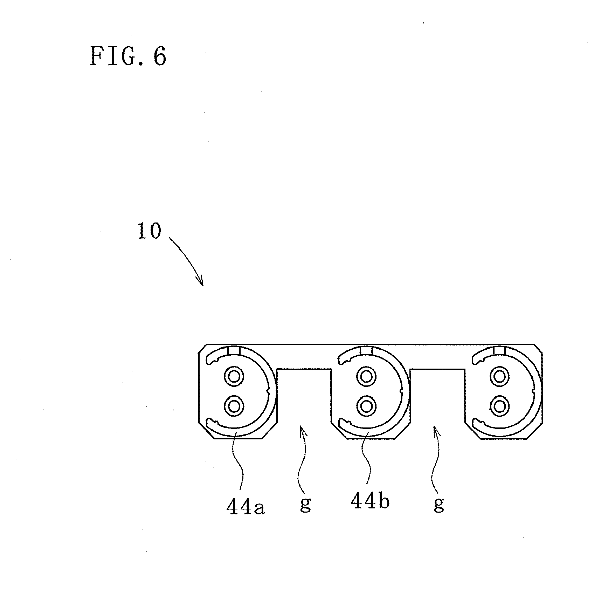

As the supporting portions 30a, 30b, and 30c are coupled by the first and second coupling members 32a and 32b, the vibration resistance performance is improved.
Further, as a space is provided under the coupling members 32a and 32b of the lead component holder 10, as illustrated in Fig. 5, chip components (one examples of electronic components) p are mounted below each of the coupling members 32a and 32b, and the area for mounting the electronic components is reduced.
Moreover, gaps g (see Fig. 4A) are respectively provided between the adjacent supporting portions 30a and 30b and the adjacent supporting portions 30b and 30c when the lead component holder 10 is viewed in planar view. Thus, it is possible to visually confirm a mounting condition and silkscreen printing of the electronic components disposed below the first and second coupling members 32a and 32b.
As illustrated in Fig. 6, the gap g between the adjacent supporting portions can be increased to base end portions of the supporting frames 44a and 44b so as to further facilitate the confirmation of the mounting condition and the silkscreen printing of the electronic components.

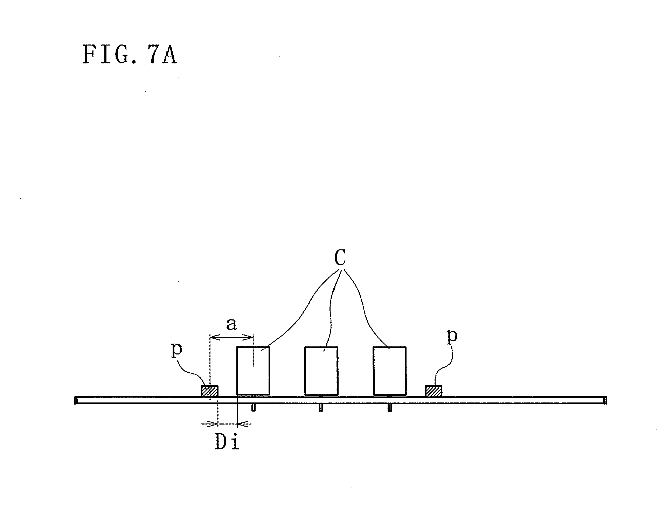

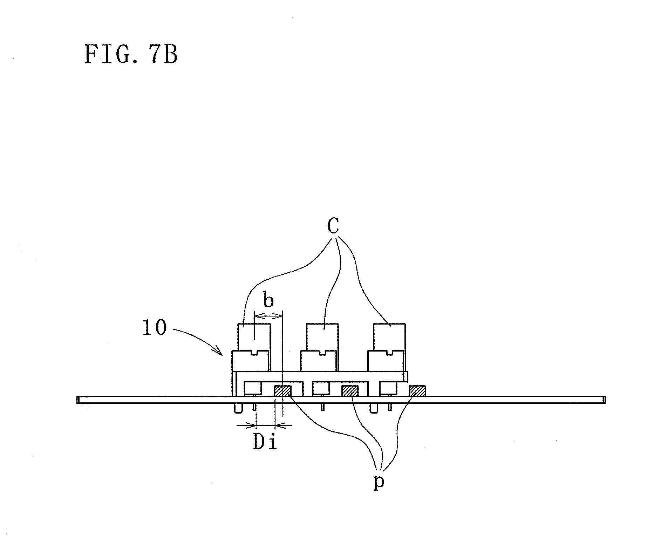

In an arrangement of the capacitor C, as illustrated in Fig. 7A, it is generally required to place the chip component p with a distance a or more from a central axis of the capacitor C in order to secure an insulation distance Di.
However, as illustrated in Fig. 7B, the lead component holder 10 according to this embodiment can secure the insulation distance Di even if the chip component p is placed with a distance b that is shorter than the distance a.

Now, a method of assembling the lead component holder 10 and the capacitors C to the printed circuit board 22 will be described.
As described above, the printed circuit board 22 includes the holes H2 for inserting the positioning pins 50 projecting from the bottom surface of the lead component holder 10 (see Fig. 8). Further, the printed circuit board 22 includes the through holes Ht to which the lead wires of the capacitors C are soldered.

For example, the lead component holder 10 and the capacitors C are assembled (mounted) on the printed circuit board 22 according to the following steps.

### First Step

The positioning pins 50 are respectively inserted into the holes H2.

### Second Step

The lead component holder 10 is adhered to the printed circuit board 22.

### Third Step

The capacitors C are inserted into the supporting portions 30a, 30b, and 30c, respectively, such that orientations of the polarities thereof are matched by using the second cut-outs 56 as the marking points.

### Fourth Step

The lead wires of the capacitors C are soldered to the through holes Ht.

In this manner, the orientations of the polarities of the capacitors C are matched by using the second cut-outs 56 as the marking points, which can reduce mistakes in assembly.
The order of the steps can be switched around as needed. For example, it is possible to perform the assembly in an order of the third step, the first step, the second step, and the fourth step.

It should be understood by those skilled in the art that various modifications, combinations, sub-combinations and alterations may occur depending on design requirements and other factors insofar as they are within the scope of the appended claims or the equivalents thereof.

For example, the lead component may be a lead component other than the capacitor that requires consideration in the insulation distance. Other examples of the lead component include a fuse and a resistor. Further, a single lead component holder may support a plurality of lead components of different kinds.

Moreover, at least two may be sufficient as the number of the supporting portions of the lead component holder.
It is not necessary to provide the supporting portions linearly. For example, the supporting portions may be provided such that directions of coupling intersect with each other.

Alternatively, the coupling members may couple the supporting portions at different heights.
Furthermore, the coupling members are not necessary to be the same size.

The number of the positioning pins is not necessarily limited, and each of the supporting portions may include a positioning pin.
The marking point may be a marking by paint; instead of the cut-out.

## Claims

1. A lead component holder **characterized by**:
a plurality of supporting portions (30a, 30b, 30c) each supporting one of lead components (C) at a position distant from a component mounting surface of a substrate (22); and
at least one of coupling members (32a, 32b), the coupling member (32a) coupling the adjacent supporting portions (30a, 30b) at a position distant from the component mounting surface, the coupling member (32b) coupling the adjacent supporting portions (30b, 30c) at a position distant from the component mounting surface, each of the supporting portions (30a, 30b, 30c) further **characterized by**:
base members (42a, 42b, 42c) having holes, the base members (42a, 42b, 42c) attached to the component mounting surface, **characterized in that** each lead of the lead components (C) is inserted in each of the holes; and
supporting frames (44a, 44b, 44c) provided on the base members (42a, 42b, 42c), **characterized in that** the lead components (C) are respectively inserted in the supporting frames (44a, 44b, 44c).

2. The lead component holder according to claim 1, **characterized in that**
viewing from a side supporting the lead component (C), each width of the coupling members (32a, 32b) in a direction intersecting with a coupling direction of the coupling members (32a, 32b) is smaller than each width of the supporting portions (30a, 30b, 30c) coupled by the coupling members (32a, 32b) in the direction intersecting with the coupling direction, and
a gap (g) is formed between the adjacent supporting portions (30a, 30b, 30c), the gap (g) allowing an electronic component (p) to be confirmed visually, the electronic component (p) disposed between the component mounting surface and the coupling members (32a, 32b).

3. The lead component holder according to claim 2, **characterized in that**
each of the lead components (C) is a polarized capacitor, and
each of the supporting frames (44a, 44b, 44c) includes a plurality of contact members (52), the contact members (52) projecting from inner walls of the supporting frames (44a, 44b, 44c), the contact members (52) in contact with the polarized capacitors, and the contact members (52) extending in a direction of each axis of the polarized capacitors.

4. The lead component holder according to claim 3, **characterized in that**
an amount of projection of each of the plurality of contact members (52) from the inner wall increases toward a direction of insertion of the polarized capacitor (C).

5. The lead component holder according to claim 4, **characterized in that**
each of the supporting frames (44a, 44b, 44c) includes a first cut-out (54) for expanding an internal diameter of each of the supporting frames (44a, 44b, 44c), and the polarized capacitors (C) are respectively inserted in the supporting frames (44a, 44b, 44c).

6. The lead component holder according to claim 5, **characterized in that**
the first cut-outs (54) are formed in the supporting frames (44a, 44b, 44c) of the plurality of supporting portions (30a, 30b, 30c), and the first cut-outs (54) face in a single direction without facing toward each other.

7. The lead component holder according to claim 6, **characterized in that**
the first cut-outs (54) are respectively formed in the supporting frames (44a, 44b, 44c) in the coupling direction of the coupling members (32a, 32b).

8. The lead component holder according to any one of claims 5 to 7, **characterized in that**
each of the supporting frames (44a, 44b, 44c) includes a marking point indicating a polarity position of the lead component (C).

9. The lead component holder according to claim 8, **characterized in that**
the marking points are respectively formed in the supporting portion (30a, 30b, 30c) in a direction different from the coupling direction.

10. The lead component holder according to claim 8 or 9, **characterized in that**
the marking point is a second cut-out (56) different from the first cut-out (54).

11. The lead component holder according to claim 7, **characterized in that**
the plurality of supporting portions (30a, 30b, 30c) are aligned in one direction.

12. The lead component holder according to any one of claims 1 to 11, **characterized in that**
out of the plurality of supporting portions, the supporting portions (30a, 30c) disposed on both ends each include a positioning pin to be fixed to the substrate.

13. An electronic device **characterized by**:
a substrate (22);
a lead component holder according to any one of the claims 1 to 12; and
an electronic component (p) mounted to the substrate (22) below the coupling members (32a, 32b).
